**Europäisches Patentamt**

**European Patent Office**

**Office européen des brevets**

(19)

(11) Veröffentlichungsnummer : **0 331 208 B1**

(12) # EUROPÄISCHE PATENTSCHRIFT

(45) Veröffentlichungstag der Patentschrift :
20.05.92 Patentblatt 92/21

(51) Int. Cl.$^5$ : **C25D 1/10,** B01D 59/18

(21) Anmeldenummer : **89105374.6**

(22) Anmeldetag : **18.03.86**

(54) **Verfahren zum Herstellen einer Vielzahl plattenförmiger Mikrostrukturkörper aus Metall.**

(30) Priorität : **22.10.85 DE 3537483**

(43) Veröffentlichungstag der Anmeldung :
**06.09.89 Patentblatt 89/36**

(60) Veröffentlichungsnummer der früheren
Anmeldung nach Art. 76 EPü : **0 224 630**

(45) Bekanntmachung des Hinweises auf die
Patenterteilung :
**20.05.92 Patentblatt 92/21**

(84) Benannte Vertragsstaaten :
**AT CH DE FR GB IT LI NL SE**

(56) Entgegenhaltungen :
**EP-A- 0 143 223**

(73) Patentinhaber : **Kernforschungszentrum
Karlsruhe GmbH
Postfach 3640
W-7500 Karlsruhe 1 (DE)**

(72) Erfinder : **Ehrfeld, Wolfgang, Dr.
Reutstrasse 27
W-7500 Karlsruhe 41 (DE)**
Erfinder : **Hagman, Peter, Dr.
Nagoldstrasse 9c
W-7514 Leopoldshafen (DE)**
Erfinder : **Maner, Asim, Dr.
Zwölfmorgen 8
W-7515 Linkenheim (DE)**
Erfinder : **Münchmeyer, Dietrich, Dr.
Hagäckerstrasse 5
W-7513 Stutensee 3 (DE)**
Erfinder : **Becker, Erwin, Prof. Dr.
Strählerweg 18
W-7500 Karlsruhe 41 (DE)**

(74) Vertreter : **Gottlob, Peter
Kernforschungszentrum Karlsruhe GmbH Abt.
PAL Weberstrasse 5 Postfach 3640
W-7500 Karlsruhe 1 (DE)**

## Beschreibung

Die Erfindung betrifft ein Verfahren zum Herstellen einer Vielzahl plattenförmiger Mikrostrukturkörper aus Metall nach dem Oberbegriff von Patentanspruch 1.

Ein Verfahren dieser Art ist aus der EP-A-0143223 bekannt. Dabei wird eine elektrisch leitende Substratplatte mit einer Photolackschicht beschichtet und sodann an ein die Mikrostrukturen aufweisendes Werkzeug angepreßt. Darauf werden die Strukturspalten des Werkzeugs mit Kunststoff ausgefüllt. Die so entstehenden Kunststoffstrukturen, deren Höhe der Höhe der herzustellenden Mikrostrukturen entspricht, verbleiben nach dem Trennen des Werkzeugs an der Photolackschicht haften. Anschließend wird der Photolack an den nicht von den Kunststoffstrukturen bedeckten Stellen durch Belichten und Entwickeln von der Substratplatte abgelöst und die Substratplatte an diesen Stellen passiviert. Schließlich werden die Kavitäten der Kunststoffnegativform galvanisch mit einem Metall aufgefüllt und die Negativform samt Substratplatte entfernt. Diese relativ große Zahl von Einzelschritten insbes. die Verwendung und die Behandlung einer Photolackschicht macht das Verfahren aufwendig und daher für eine Massenfertigung weniger geeignet.

Die Erfindung hat zur Aufgabe, ein Verfahren der gattungsgemäßen Art so zu gestalten, daß der Herstellungsaufwand verringert und damit bessere Voraussetzungen für eine Massenherstellung geschaffen werden.

Für die Lösung dieser Aufgabe werden die im Kennzeichen des Patentanspruchs enthaltenen Maßnahmen vorgeschlagen.

Mit der Erfindung wird außer der Reduzierung auch eine Vereinfachung der einzelnen, dem Galvanisierungsprozeß vorausgehenden Verfahrensschritte erreicht.

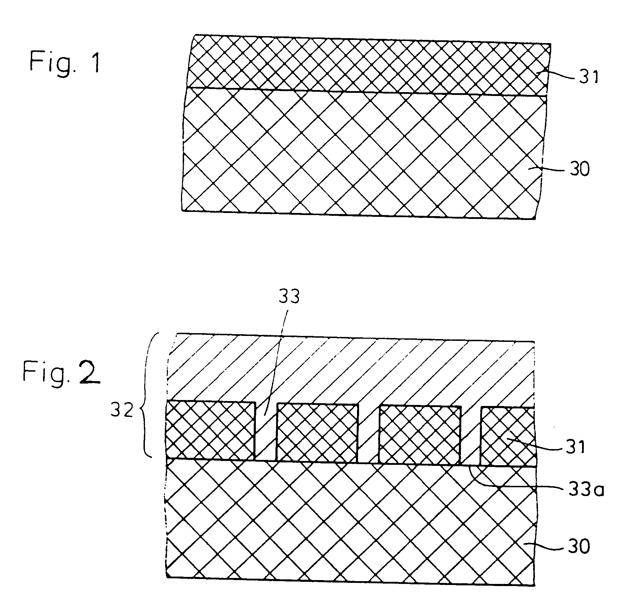

Ein Ausführungsbeispiel des erfindungsgemäßen Verfahrens wird anhand der Figuren 1 und 2 veranschaulicht:

Zunächst werden in eine PLEXIGLAS®-Formmasse Typ 8N von Fa. Röhm 20 Gew.- % Leitruß mit Hilfe eines kontinuierlichen Schneckenkneters eingearbeitet und daraus 5 mm dicke Schichten 30 durch Spritzguß hergestellt, die als elektrisch leitende Abformmasse dienen. Über diese Platten wird die PLEXIGLAS®-Formmasse Typ 6NIe als elektrisch isolierende Abformmasse 31 mit einer Höhe von 0,3 mm gespritzt, die eine um 18 K geringere Erweichungstemperatur hat (Figur 1). In diesen Verbund wird bei einer Temperatur von 110°C das Werkzeug 32 eingepreßt, so daß die Stirnflächen 33a der Mikrostrukturen 33 des Werkzeugs 32 die elektrisch leitende Abformmasse 30 gerade berühren (Figur 2). Nach dem Abkühlen des Werkzeugs wird entformt. Die so hergestellte Negativform wird galvanisch mit einem Metall aufgefüllt, wobei die Schicht 30 als Elektrode für die Galvanik dient. Nach dem Entfernen der Negativform 30, 31 verbleibt ein Mikrostrukturkörper aus Metall, dessen Mikrostrukturen den Strukturen 33 des Werkzeugs 32 entsprechen.

## Patentansprüche

1. Verfahren zum Herstellen einer Vielzahl plattenförmiger Mikrostrukturkörper aus Metall, bei dem durch wiederholtes Abformen eines die Mikrostrukturen aufweisenden Werkzeugs mit einer elektrisch isolierenden Abformmasse Negativformen der Mikrostrukturen erzeugt werden, die galvanisch mit einem Metall aufgefüllt werden, wonach die Negativformen entfernt werden, und bei dem die elektrisch isolierende Abformmasse mit einer elektrisch leitenden, als Elektrode für die Galvanik dienenden Schicht verbunden wird, wobei die Dicke der elektrisch isolierenden Abformmasse der Höhe der herzustellenden Mikrostrukturen entspricht, dadurch gekennzeichnet, daß vor dem Abformen eine Schicht (31) aus der elektrisch isolierenden Abformmasse mit der Schicht (3) aus elektrisch leitender Abformmasse verbunden wird, und daß das Werkzeug (31) so weit in die Schicht (31) aus der elektrisch isolierenden Abformmasse eingedrückt wird, bis die Stirnflächen (33a) der Mikrostrukturen (33) des Werkzeugs (32) die Schicht (30) aus elektrisch leitender Abformmasse berühren.

## Claims

1. Process for producing a plurality of plate-like microstructural bodies from metal, wherein, by repeatedly moulding a tool, which includes the microstructures, using an electrically insulating moulding compound, negative moulds of the microstructures are produced, which are galvanically filled with a metal, whereupon the negative moulds are removed, and wherein the electrically insulating moulding compound is bonded to an electrically conductive layer, which serves as the electrode for the galvanic operation, the thickness of the electrically insulating moulding compound corresponding to the height of the microstructures to be produced, characterised in that, prior to the moulding operation, a layer (31) of the electrically insulating moulding compound is bonded to the layer (30) of the electrically conductive moulding compound, and in that the tool (32) is pressed to such an extent into the layer (31) of the electrically insulating moulding compound until the end faces (33a) of the microstructures (33) of the tool (32) are in contact with the layer (30) of the electrically conductive moulding compound.

## Revendications

1. Procédé pour la fabrication d'un corps présentant une microstructure à plans multiples, à base de métal, dans lequel on produit par moulage répété d'un outil présentant les microstructures, avec une matière à mouler électro-isolante, des moules négatifs des microstructures qui sont remplis par galvanoplastie avec un métal, à la suite de quoi on élimine les moules négatifs, et dans lequel la matière à mouler électro-isolante est connectée avec une couche conductrice de l'électricité, servant d'électrode pour la galvanoplastie, l'épaisseur de la matière à mouler électro-isolante correspondant à la hauteur des microstructures à obtenir, caractérisé en ce que, avant le moulage, une couche (31) à base de la matière à mouler électro-isolante est connectée avec la couche (30) à base de matière à mouler électro-conductrice et en ce que l'outil (32) est imprimé dans la couche (31) à base de matière à mouler électro-isolante, jusqu'à ce que les faces avant (33a) des microstructures (33) de l'outil (32) entrent en contact avec la couche (30) à base de matière à mouler électro-conductrice.

Fig. 1

Fig. 2